# EUROPEAN PATENT APPLICATION

(11) **EP 2 216 826 A1**
(43) Date of publication of application: **11.08.2010**
(21) Application number: 08854520.7
(22) Date of filing: 21.11.2008
(51) Int. Cl.: H01L 31/04

(54) **SILICON THIN FILM PHOTOELECTRIC CONVERSION DEVICE**

(30) Priority: 30.11.2007 JP 2007310487
(71) Applicant: Kaneka Corporation, Kita-ku Osaka-shi, Osaka 530-8288 (JP)
(72) Inventor: TAWADA, Yuko, Otsu-shi Shiga 520-0104 (JP); GOTO, Masahiro, Otsu-shi Shiga 520-0104 (JP)
(74) Representative: Vossius & Partner
(86) International application number: PCT/JP2008/071208
(87) International publication number: WO 2009/069544

(57) **Abstract**

The invention intends to provide a silicon-based thin-film photoelectric conversion device with conversion efficiency improved at low cost. Specifically, disclosed is a thin-film silicon-based photoelectric conversion device (5) comprising a crystalline photoelectric conversion unit (3), wherein one-conductivity-type semiconductor layer (31), a crystalline silicon-based photoelectric conversion layer (322), and a reverse-conductivity-type semiconductor layer (33) are sequentially stacked. This silicon thin film photoelectric conversion device (5) is also **characterized in that** a substantially i-type crystalline silicon intervening layer (321), which is made of a material different from that of the photoelectric conversion layer (322), is disposed between the one-conductivity-type semiconductor layer (31) and the photoelectric conversion layer (322), and the photoelectric conversion layer (322) contacts directly with the intervening layer (321).

## Description

### TECHNICAL FIELD

The present invention relates to a performance improvement in a silicon-based thin-film photoelectric conversion device.

### BACKGROUND ART

In recent years, in order to satisfy requirements for both lower cost and higher efficiency in a solar cell, which is as a typical example of a photoelectric conversion device, a thin-film solar cell with a small amount of raw materials used has been spotlighted and vigorously developed. In particular, a method for forming a high-quality silicon-based semiconductor layer on an inexpensive substrate such as glass by using a low-temperature process at 400°C or less has been expected as a method for realizing lower cost.

A thin-film solar cell generally comprises a transparent electrode, one or more semiconductor thin-film photoelectric conversion units, and a back electrode laminated sequentially on a substrate. One of the photoelectric conversion units includes an i-type layer (also referred to as a photoelectric conversion layer), which is substantially an intrinsic semiconductor, sandwiched between a p-type layer and an n-type layer as conductive layers. Photoelectric conversion is caused substantially in the i-type layer, so that whether the conductive layers are crystalline or amorphous, the units such that the i-type layer is amorphous are referred to as amorphous photoelectric conversion units, and the units such that the i-type layer is crystalline are referred to as crystalline photoelectric conversion units. Presently, a crystalline thin-film solar cell using crystalline photoelectric conversion units has been actively studied in addition to a conventional amorphous thin-film solar cell using amorphous photoelectric conversion units. In addition, a stacked type thin-film solar cell with those units stacked, referred to as a hybrid solar cell, has been put to practical use.

In particular, both lower cost and higher efficiency have been expected to be satisfied in a crystalline silicon-based thin-film solar cell, since performance deterioration due to photodegradation (Staebler-Wronski effect) observed in an amorphous silicon-based thin-film solar cell is not caused and the same production processes as an production of amorphous silicon-based thin-film solar cell may be applied. And thus, an improvement in photoelectric conversion characteristics of the crystalline silicon-based thin-film solar cell has been studied.

For example, Patent Document 1 discloses a method for improving photoelectric conversion characteristics in a silicon-based thin-film photoelectric conversion device, in which only a low-temperature process at 400°C or less is applied in its formation and thus an inexpensive substrate such as glass is usable, by decreasing crystal grain boundaries and defect in a crystalline silicon-based thin-film photoelectric conversion layer. Specifically, in a silicon-based thin-film photoelectric conversion device such that all semiconductor layers included in the photoelectric conversion units are formed at low temperature by a plasma enhanced CVD method, an extremely thin amorphous silicon-based intervening layer of the substantially i-type is inserted into an interface between the photoelectric conversion layer and the conductive layer as an underlayer thereof. The density of silicon crystals with small particle sizes in the surface of the underlayer is adequately controlled by an intervening layer. The silicon crystals with small particle-size causes a development of a crystalline nucleus in the crystalline silicon-based photoelectric conversion layer, but this intervening layer appropriately controls crystalline nucleus density adequately in the growth initial stage of the photoelectric conversion layer, so that the high-quality crystalline photoelectric conversion layer with less crystal grain boundaries, less intracrystalline defect and strong crystalline orientation in one direction is obtained.

Moreover, in a thin-film solar cell comprising microcrystalline silicon as the chief material, a method four improving open circuit voltage (Voc) of the thin-film solar cell by decreasing crystal volume fraction on the p/i layer interface is disclosed in Patent Document 2. Specifically, in a thin-film solar cell such that the p layer is made of microcrystalline silicon and the i layer and the n layer are made of microcrystalline silicon or polycrystalline silicon, an intervening layer is inserted between the i layer and the semiconductor layer (the p layer) on the light incidence side thereof, wherein the intervening layer comprises microcrystalline silicon and contains impurities by 1 × 10²⁰ atom/cm³ or more for increasing band gap of amorphous silicon component. Examples of the impurities for increasing band gap include carbon, nitrogen, and oxygen.

The terms "crystalline" and "microcrystalline" as used herein also refer to materials containing amorphous state partially as generally used in the art.

The crystalline silicon-based thin-film photoelectric conversion device and the microcrystalline silicon-based thin-film solar cell as described above are characterized in that the photoelectric conversion layer is thin as compared with a solar cell adopting monocrystalline or polycrystalline silicon of conventional bulk, while the problem is that light absorption of the photoelectric conversion layer is limited by film thickness thereof. Then, in order to utilize incident light into the photoelectric conversion units more effectively, a contrivance is made such that the surface of a transparent conductive film or a metal layer contacting with the photoelectric conversion units is minutely roughened (textured). Specifically, light is scattered on the interface to thereafter extend optical path length by making the light enter the photoelectric conversion units and thereby light absorption amount in the photoelectric conversion layer is increased. This technique is called "optical confinement" and becomes an important elemental technique in putting a thin-film solar cell with high photoelectric conversion efficiency to practical use.

Generally, in the case of using a transparent electrode deposited on a substrate, haze ratio has been mainly used as an index for evaluating light scattering performance of the transparent electrode contributing to optical confinement effect. The haze ratio is represented by (diffusion light transmittance/total light transmittance) × 100 [%] (JIS K7136). The measurement by a haze meter with the use of D65 light source or C light source is general as a simple method for evaluating the haze ratio. The transparent electrode with a haze ratio of approximately 10% in a state, where the transparent electrode is formed on a transparent substrate such as glass, has been widely used in an amorphous thin-film solar cell put to practical use presently.
Patent Document 1: Japanese Unexamined Patent Publication No. 11-87742
Patent Document 2: Japanese Unexamined Patent Publication No. 2003-258286

### DISCLOSURE OF THE INVENTION

### PROBLEMS TO BE SOLVED BY THE INVENTION

First, in the method described in Patent Document 1, wherein a silicon-based thin-film photoelectric conversion device such that all semiconductor layers included in the photoelectric conversion units are formed by a plasma enhanced CVD method, the effect of improving photoelectric conversion characteristics is easily obtained comparatively. However, it has proved that a remarkable improvement in conversion efficiency is not obtained in the case of increasing the degree of minute surface irregularities of the transparent electrode contributing to optical confinement effect for the purpose of achieving even higher efficiency of the silicon-based thin-film photoelectric conversion device. The reason therefor is assumed to be that, in the case where the surface irregularity of the transparent electrode is increased, the control of crystalline nucleus density in the growth initial stage of the crystalline silicon-based photoelectric conversion layer does not sufficiently function in the method of Patent Document 1.

On the other hand, in the microcrystalline silicon thin-film solar cell of Patent Document 2, crystal volume fraction on the p/i layer interface is intended to change abruptly for improving Voc, and the intervening layer containing numerous impurities is utilized on the interface. This intervening layer is characterized by having low crystallinity as compared with the semiconductor layer (the p layer) on the light incidence side of the i layer. The intervening layer disclosed in examples of Patent Document 2 is formed by adding CH₄ in the film formation of the p layer, and recognized to be a film having p-type electrical conductivity. Accordingly, this intervening layer having p-type electrical conductivity is an inactive layer which contributes to no photoelectric conversion, and light absorbed in the p-type dopant does not contribute to electric power generation but causes a decrease in short-circuit current density (Jsc). Therefore, it has proved that the characteristics thereof are not improved in the thin-film solar cell of Patent Document 2.

In view of the background art as described above, the object of the present invention is to provide a silicon-based thin-film photoelectric conversion device with conversion efficiency improved at low cost.

### MEANS FOR SOLVING THE PROBLEMS

A silicon-based thin-film photoelectric conversion device according to the present invention comprising a crystalline photoelectric conversion unit which includes a one-conductivity-type semiconductor layer, a crystalline silicon-based photoelectric conversion layer, and a reverse-conductivity-type semiconductor layer stacked sequentially, and a substantially i-type crystalline silicon-based thin-film intervening layer, which is made of a material different from the photoelectric conversion layer, disposed between the one-conductivity-type semiconductor layer and the photoelectric conversion layer. The photoelectric conversion layer contacts directly with the intervening layer.

The thickness of the intervening layer is preferably within a range of 0.1 to 30 nm, more preferably within a range of 0.1 to 10 nm. Moreover, the intervening layer preferably contains any of crystalline silicon oxide, crystalline silicon carbide, and crystalline silicon nitride. In addition, it is preferable to further include an amorphous photoelectric conversion unit comprising a one-conductivity-type semiconductor layer, an amorphous silicon-based photoelectric conversion layer, and a reverse-conductivity-type semiconductor layer stacked sequentially on the light incidence side of the crystalline photoelectric conversion unit.

In one embodiment of the present invention, it is preferable to further include a transparent electrode having surface irregularities on the light incidence side of the above-mentioned crystalline photoelectric conversion unit, and that the haze ratio of the transparent electrode is in the range of 20 to 40%.

### EFFECT OF THE INVENTION

According to the present invention as described above, the i-type crystalline silicon-based intervening layer allows the crystalline silicon-based thin-film photoelectric conversion layer to be of higher quality and the characteristics of a semiconductor junction are improved, so that a silicon-based thin-film photoelectric conversion device with conversion efficiency improved may be provided at low cost by a plasma enhanced CVD method.

### BRIEF DESCRIPTION OF THE DRAWINGS

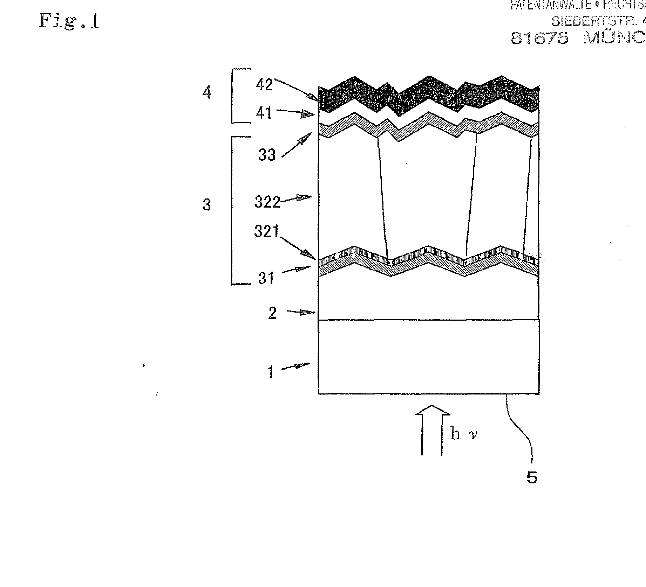

Fig. 1 is a schematic cross-sectional view showing stacked structure of a thin-film photoelectric conversion device according to one embodiment of the present invention.

### REFERENCE NUMERALS

- 1: transparent substrate
- 2: transparent electrode
- 3: crystalline photoelectric conversion unit
- 31: one-conductivity-type semiconductor layer
- 321: i-type crystalline silicon-based intervening layer
- 322: crystalline silicon-based photoelectric layer conversion
- 33: reverse-conductivity-type semiconductor layer
- 4: back electrode
- 41: transparent conductive oxide layer
- 42: metal layer
- 5: silicon-based thin-film photoelectric conversion device

### BEST MODE FOR CARRYING OUT THE INVENTION

Fig. 1 is a schematic cross-sectional view showing laminated structure of a silicon-based thin-film photoelectric conversion device according to an embodiment of the present invention. A silicon-based thin-film photoelectric conversion device 5 comprises a transparent electrode 2, a crystalline photoelectric conversion unit 3, and a back electrode 4 laminated sequentially on a transparent substrate 1. The crystalline photoelectric conversion unit 3 comprises a one-conductivity-type semiconductor layer 31, an i-type crystalline silicon-based intervening layer 321, a crystalline silicon-based photoelectric conversion layer 322, and a reverse-conductivity-type semiconductor layer 33 stacked sequentially. The back electrode 4 includes a conductive oxide layer 41 and a metal layer 42 stacked sequentially. Then, light energy (hν) to be subjected to photoelectric conversion enters the thin-film photoelectric conversion device 5 from the transparent substrate 1 side.

The transparent substrate 1 located on the light incidence side of the photoelectric conversion device is preferably as transparent as possible for transmitting more light to be absorbed in the photoelectric conversion unit 3; examples of a material therefor include a glass plate and a transparent plastic film. For the same reason, it is desirable that anti-reflection coating is provided on the light incidence plane of the transparent substrate 1 so as to decrease reflection loss.

Zinc oxide (ZnO), tin oxide (SnO₂), indium tin oxide (ITO) or the like is used for the transparent electrode 2, and the transparent electrode of the crystalline silicon-based thin-film photoelectric conversion device is preferably made mainly of ZnO. The reason therefor is that ZnO has higher plasma resistance than SnO₂ and ITO, and thus a ZnO film is poorly reduced even if plasma containing hydrogen in high density is irradiated during the deposition of the crystalline thin-film photoelectric conversion layer. Accordingly, a ZnO film is appropriate as a transparent electrode material for the crystalline thin-film photoelectric conversion device by reason that incident light is poorly absorbed by blackening region resulting from reduction, and the possibility of decreasing transmitted light amount through the photoelectric conversion layer is low.

The transparent electrode 2 preferably has a haze ratio of 10% or more in a state of being formed on the transparent substrate 1, with regard to surface irregularities of the transparent electrode 2, so that optical confinement effect suitable for the photoelectric conversion device is obtained. The transparent electrode 2 more preferably has a haze ratio of 20 to 40% for remarkably improving photoelectric conversion characteristics. In the case where surface irregularities of the transparent electrode 2 are small and the haze ratio is less than 20%, sufficient optical confinement effect may not be obtained. On the contrary, in the case where surface irregularities of the transparent electrode 2 are large and the haze ratio is more than 40%, layer defect and electrical short circuit may be caused in the photoelectric conversion device to cause characteristic deterioration of the photoelectric conversion device.

With regard to the photoelectric conversion unit formed on the transparent electrode 2, one unit 3 may be provided as shown in Fig. 1 or a plurality of units may be laminated. At least one photoelectric conversion unit 3 included in the photoelectric conversion device preferably absorbs the main wavelength range (400 to 1200 nm) of sunlight, and preferably includes the crystalline silicon-based photoelectric conversion layer 322, for example. It should be noted that "silicon-based" materials include silicon alloy materials such as silicon carbide and silicon germanium in addition to silicon.

The one-conductivity-type semiconductor layer 31 included in the photoelectric conversion unit 3 is deposited on the transparent electrode 2 by a plasma enhanced CVD method, for example. Examples of this one-conductivity-type semiconductor layer 31 include a p-type microcrystalline silicon-based layer doped with boron as conductivity determining impurity atom by 0.01% by atom or more, or an n-type microcrystalline silicon-based layer doped with phosphorus by 0.01% by atom or more. However, the one-conductivity-type semiconductor layer 31 is not limited thereto, and the p-type impurity atom may be aluminum or the like and an amorphous silicon-based layer may be used as the p-type layer. Alloy materials such as amorphous or microcrystalline silicon carbide, silicon oxide, and silicon germanium may be used as the p-type layer. The thickness of the one-conductivity-type microcrystalline silicon-based layer 31 is preferably 3 nm or more and 100 nm or less, more preferably 5 nm or more and 50 nm or less.

The substantially i-type crystalline silicon-based intervening layer 321 as the most important characteristic of the present invention is formed on the one-conductivity-type semiconductor layer 31. This intervening layer 321 is deposited under a substrate temperature of 300°C or less by a CVD method such as a plasma enhanced CVD method, and formed of a crystalline silicon-based thin film such that the density of conductivity determining impurity atom is 1 × 10¹⁸ cm⁻³ or less. More specifically, the intervening layer 321 is preferably any of crystalline silicon oxide, crystalline silicon carbide, and crystalline silicon nitride as alloy materials, and formed out of a material different from the crystalline silicon-based photoelectric conversion layer 322 deposited thereon subsequently. The substrate temperature herein is measured as a temperature of the plane on which the substrate contacts with a heating unit of film formation equipment.

In this manner, the presence of the i-type crystalline silicon-based intervening layer 321 improves open circuit voltage (Voc) and short-circuit current density (Jsc) of the silicon-based thin-film photoelectric conversion device to consequently bring a tendency to improve conversion efficiency. The mechanism for improving the characteristics is not clear and yet assumed to be that the presence of the intervening layer 321 causes the barrier effect of restraining dope impurities of the one-conductivity-type semiconductor layer 31 from diffusing into the i-type crystalline photoelectric conversion layer 322, and meanwhile allows the effect of preventing hydrogen atoms in the plasma from adversely affecting the one-conductivity-type semiconductor layer 31 in depositing the i-type crystalline photoelectric conversion layer 322 by a plasma enhanced CVD method.

In order to obtain optical confinement effect suitable for the photoelectric conversion device as described above, in the case where the transparent electrode 2 has surface irregularities and the haze ratio thereof is within the predetermined range, a remarkable improvement in conversion efficiency tends to be difficult to obtain even though the substantially i-type amorphous silicon-based intervening layer is inserted on the one-conductivity-type semiconductor layer as described in Patent Document 1. The cause thereof is assumed to be that in the case where surface irregularity of the transparent electrode are large, in other words, the haze ratio of the transparent electrode 2 is high, the one-conductivity-type semiconductor layer also has so large surface irregularity that the control of crystalline nucleus density in the growth initial stage of the crystalline silicon-based photoelectric conversion layer does not sufficiently function.

In the present invention, on the contrary, the substantially i-type crystalline silicon-based intervening layer, which is formed out of a material different from the i-type crystalline photoelectric conversion layer 322, is disposed between the one-conductivity-type semiconductor layer and the photoelectric conversion layer. It is assumed, therefore, that even in the case where the haze ratio of the transparent electrode is high, the performance of optical confinement effect allows high conversion efficiency to be achieved while restraining the diffusion of dope impurities of the one-conductivity-type semiconductor layer into the i-type crystalline photoelectric conversion layer 322 and the adverse influence of hydrogen atoms in the plasma on the one-conductivity-type semiconductor layer 31 in depositing the i-type crystalline photoelectric conversion layer, as described above. That is, according to the present invention using the crystalline silicon-based intervening layer formed out of a material different from the i-type crystalline photoelectric conversion layer, the covering state of the interface between the one-conductivity-type semiconductor layer reflecting the surface shape of the transparent electrode and the i-type crystalline photoelectric conversion layer is favorable as compared with the case of using the amorphous intervening layer as described in Patent Document 1. And therefore, the generation of crystalline nucleus in the growth initial stage of the i-type crystalline photoelectric conversion layer formed on the intervening layer is controlled, so that carrier recombination due to defect in the film is inhibited, which is assumed to lead to high conversion efficiency.

In addition, the intervening layer 321 is an i-type crystalline layer with small absorption coefficient, made of a wide-gap material as compared with crystalline silicon, such as crystalline silicon oxide, crystalline silicon carbide, and crystalline silicon nitride, so that current generation in the photoelectric conversion layer is not decreased even though the intervening layer 321 is located on the light incidence side of the i-type crystalline photoelectric conversion layer 322, whereby it is assumed that short-circuit current density (Jsc) is improved.

The thickness of the intervening layer 321 is preferably within a range of 0.1 to 30 nm, more preferably within a range of 0.1 to 10 nm, even more preferably within a range of 0.5 to 5 nm. The reason therefor is that in the case where the layer is too thin, a sufficient effect of improving the characteristics may not be achieved. In the case where the layer is too thick, on the contrary, crystal volume fraction and crystal orientation of the crystalline photoelectric conversion layer 322 formed subsequently is affected to result in the deterioration of film quality and cause the characteristic deterioration of the photoelectric conversion device. The thickness of the thin film herein is obtained by calculating from deposition time under the predetermined CVD conditions. Accordingly, in the case where the layer is very thin, the intervening layer 321 does not have completely continuous and uniform thickness but has a possibility of becoming a netted thin film including many island-shaped portions.

The crystalline silicon-based photoelectric conversion layer 322 is deposited on the intervening layer 321 at a substrate temperature of 300°C or less by a plasma enhanced CVD method or the like. The crystalline silicon-based photoelectric conversion layer 322 preferably contains many hydrogen atoms for terminating and deactivating crystal grain boundaries and intracrystalline defect by being deposited at comparatively low temperature. Specifically, the hydrogen content of the photoelectric conversion layer is preferably within a range of 1 to 30% by atom. The photoelectric conversion layer is preferably formed as a substantially intrinsic semiconductor layer such that the density of conductivity determining impurity atom is 1 × 10¹⁸ cm⁻³ or less. In addition, many of the crystal grains contained in the crystalline silicon-based photoelectric conversion layer preferably grows columnarly extending in the film thickness direction, and preferably have (110) preferred orientation plane in parallel with the film plane.

The film thickness of the crystalline silicon-based photoelectric conversion layer 322 is preferably 1 µm or more from the viewpoint of light absorption and preferably 10 µm or less from the viewpoint of restraining the peeling due to internal stress of the layer. Here, the crystalline thin-film photoelectric conversion unit preferably absorbs the main wavelength range (400 to 1200 nm) of sunlight, so that a crystalline silicon carbide layer (such as a crystalline silicon carbide layer made of crystalline silicon containing carbon of 10% by atom or less) or a crystalline silicon germanium layer (such as a crystalline silicon germanium layer made of crystalline silicon containing germanium of 30% by atom or less) utilizing alloy materials may be formed instead of the crystalline silicon-based photoelectric conversion layer.

The conductive semiconductor layer 33 of a type different from the one-conductivity-type semiconductor layer 31 is deposited on the crystalline silicon-based photoelectric conversion layer 322 by a plasma enhanced CVD method, for example. Examples of this reverse-conductivity-type semiconductor layer 33 include an n-type amorphous or microcrystalline silicon-based layer doped with phosphorus by 0.01% by atom or more, and a p-type amorphous or microcrystalline silicon-based layer doped with boron by 0.01% by atom or more. However, aluminum or the like may also be used as the p-type impurity atom. Alloy materials such as amorphous or microcrystalline silicon carbide, silicon oxide, and silicon germanium may be used as the p-type layer. In the case where the amorphous silicon-based layer is used as the reverse-conductivity-type semiconductor layer 33, the film thickness thereof is preferably 1 nm or more and 50 nm or less. On the other hand, in the case where the microcrystalline silicon-based layer is used as the reverse-conductivity-type semiconductor layer 33, the film thickness thereof is preferably 3 nm or more and 100 nm or less, more preferably 5 nm or more and 50 nm or less.

The back electrode 4 including at least the metal layer 42 is formed on the photoelectric conversion unit 3. For this metal layer 42, one or more layers including at least one kind selected from Al, Ag, Au, Cu, Pt and Cr are preferably deposited by a sputtering method or a vacuum deposition method. The conductive oxide layer 41 such as ITO, SnO₂ and ZnO is preferably inserted between the photoelectric conversion unit 3 and the metal layer 42. This conductive oxide layer 41 may improve adhesion properties between the photoelectric conversion unit 3 and the metal layer 42, function so as to maintain highlight reflectance of the metal layer 41, and function so as to prevent metallic element from diffusing from the metal layer 41 into the photoelectric conversion unit 3.

In Fig. 1, light energy (hv) is drawn so as to enter from the transparent substrate 1 side, namely, from downward, but yet it is needless to say that light may be made to enter from upward; in which case, the transparent electrode 2 and the back electrode 4 are reversely disposed.

Though not shown in figure, it will be apparent that the present invention may also be applied to a tandem type photoelectric conversion device, in which an amorphous photoelectric conversion unit and a crystalline photoelectric conversion unit are sequentially stacked on the transparent electrode 2. The amorphous photoelectric conversion unit includes a one-conductivity-type semiconductor layer, an amorphous photoelectric conversion layer and a reverse-conductivity-type semiconductor layer. The amorphous silicon-based material may have sensitivity to light of approximately 360 to 800 nm and the crystalline silicon-based material may have sensitivity to light of up to approximately 1200 nm longer than that of the amorphous silicon-based material. Accordingly, the tandem type photoelectric conversion device, in which the amorphous silicon-based photoelectric conversion unit and the crystalline silicon-based photoelectric conversion unit are stacked in this order from the light incidence side, may effectively utilize incident light in wider wavelength range. It is needless to say that the crystalline photoelectric conversion unit included in the tandem type photoelectric conversion device may also be formed in the same manner as the above-mentioned embodiment.

The amorphous photoelectric conversion unit may be formed by disposing each of the semiconductor layers in order of the pin type by a plasma enhanced CVD method. Specifically, a p-type amorphous silicon-based layer doped with boron by 0.01% by atom or more, an intrinsic amorphous silicon-based photoelectric conversion layer, and an n-type amorphous silicon-based layer doped with phosphorus by 0.01% by atom or more may be deposited in the order. Here, a microcrystalline silicon-based layer may be used as the p-type layer. Alloy materials such as amorphous or microcrystalline silicon carbide, silicon nitride, silicon oxide, and silicon germanium may be used as the p-type layer. Alloy materials such as silicon, carbide and silicon germanium may be used as the amorphous photoelectric conversion layer. It is desirable that the amorphous silicon-based photoelectric conversion layer contains hydrogen by 2 to 15% by atom in order to decrease current loss due to carrier recombination, whereby hydrogen may decrease defect (dangling bond) density. It is desirable that the film thickness of the amorphous silicon-based photoelectric conversion layer is 50 nm or more and 500 nm or less for decreasing deterioration due to light irradiation. A microcrystalline silicon-based layer may be used as the n-type layer. The film thickness of the microcrystalline silicon-based layer or the amorphous silicon-based layer of conductive types (p-type and n-type) is preferably 3 nm or more and 100 nm or less, more preferably 5 nm or more and 50 nm or less.

In the case where the photoelectric conversion device is a thin-film solar cell, the back electrode side may be protected from the external environment by sealing resin (not shown).

### EXAMPLES

Some Examples of the present invention are hereinafter described in conjunction with some Comparative Examples. However, it is needless to say that the present invention is not limited to the following Examples.

### (Comparative Example 1)

A thin-film photoelectric conversion device such that the i-type crystalline silicon-based intervening layer 321 in Fig. 1 was omitted was produced as Comparative Example 1 for comparison with the present invention.

Specifically, a glass substrate 125 mm square having a thickness of 0.7 mm was used as a transparent substrate 1. A B-doped ZnO layer having pyramidal minute surface irregularities was deposited having a thickness of 1.7 µm as the transparent electrode 2 on the glass substrate 1 by a low-pressure CVD method. Diethyl zinc (DEZ) as raw material gas, water and diborane gas as dopant gas were used in the low-pressure CVD. In the substrate with the transparent electrode obtained here, the haze ratio was 25% and the sheet resistance of the electrode layer was approximately 10 Ω/□.

A p-type microcrystalline silicon layer 31 having a thickness of 15 nm, a crystalline silicon photoelectric conversion layer 322 having a thickness of 2.0 µm, and an n-type microcrystalline silicon layer 33 having a thickness of 20 nm were sequentially deposited on the transparent electrode 2 by a plasma enhanced CVD method to thereby form a crystalline silicon photoelectric conversion unit. Thereafter, an Al-doped ZnO layer 41 having a thickness of 90 nm and an Ag layer 42 having a thickness of 200 nm were sequentially deposited as a back electrode 4 by a sputtering method.

The crystalline silicon photoelectric conversion layer 322 was deposited by an RF (radio frequency) plasma enhanced CVD method on the following conditions. That is, the substrate temperature was 200°C, silane and hydrogen were used as raw material gas, and the pressure in a reaction chamber was 660 Pa. The RF power density was 300 mW/cm². Secondary ion mass spectrometry shows that the obtained crystalline silicon photoelectric conversion layer 322 had 5% by atom-hydrogen content and X-ray diffraction shows that the obtained crystalline silicon photoelectric conversion layer 322 had (110) preferred orientation plane parallel with the film plane.

Output characteristics of the photoelectric conversion device of Comparative Example 1 obtained as described above were measured by radiating light of AM 1.5 at normal temperature with an intensity of 100 mW/cm². Voc was 0.522 V, Jsc was 24.8 mA/cm², the fill factor (F.F.) was 0.713, and the conversion efficiency (Eff.) was 9.2%. These characteristics in Comparative Example 1 are summarized in Table 1.

**[Table 1]**

| | Intervening layer | Intervening layer thickness (nm) | Transparent electrode | Photoelectric conversion characteristics | | | |
|---|---|---|---|---|---|---|---|
| | | | Haze ratio (%) | Voc (V) | Jsc (mA/cm²) | F.F. | Eff. (%) |
| Example 1 | I : µc-SiO | 2 | 25 | 0.545 | 25.2 | 0.724 | 9.9 |
| Example 2 | I : µc-SiO | 5 | 25 | 0.548 | 25.2 | 0.720 | 9.9 |
| Example 3 | I : µc-SiC | 2 | 25 | 0.539 | 25.0 | 0.718 | 9.7 |
| Comparative Example 1 | - | 0 | 25 | 0.522 | 24.8 | 0.713 | 9.2 |
| Comparative Example 2 | i : a-Si | 2.7 | 25 | 0.529 | 24.7 | 0.721 | 9.4 |
| ComparativeExample 3 | P : µc-Sic | 3 | 25 | 0.519 | 24.5 | 0.715 | 9.1 |

### (Example 1)

In Example 1 of the present invention, a photoelectric conversion device 5 corresponding to Fig. 1 was produced. That is, the photoelectric conversion device of Example 1 is different from Comparative Example 1 only in that the i-type crystalline silicon-based intervening layer 321 having a thickness of 2 nm is inserted.

A crystalline silicon oxide layer deposited by an RF plasma method on the following conditions was used as the intervening layer 321 in Fig. 1. Specifically, the substrate temperature was 200°C, silane, hydrogen, and carbon dioxide were used as raw material gas, and the pressure in a reaction chamber was 660 Pa. The flow ratio of silane and carbon dioxide was 1:1, and the RF power density was 300 mW/cm². In an i-type crystalline silicon oxide (µc-SiO) film having a thickness of 300 nm deposited directly on the glass substrate under the same conditions as the film forming conditions above, the dark conductivity was 6.6 × 10⁻⁹ S/cm, the photoconductivity was 4.5 × 10⁻⁷ S/cm, the photosensitivity (photoconductivity/dark conductivity) was 68, the crystal volume fraction measured by Raman spectrum measurement was approximately 80% and the boron concentration was less than 1 × 10¹⁸ cm⁻³.

Output characteristics of the photoelectric conversion device obtained in Example 1 were measured by radiating light of AM 1.5 at normal temperature with an intensity of 100 mM/cm². Voc was 0.545 V, Jsc was 25.2 mA/cm², F.F. was 0.724, and Eff. was 9.9%. These characteristics in Example 1 are also summarized in Table 1.

In Table 1, the values of Voc and Jsc were improved to consequently improve Eff. in Example 1 as compared with Comparative Example 1. Output characteristics of the photoelectric conversion device obtained in Example 1 were measured again after radiating light of AM 1.5 under an environment of 50°C with an intensity of 100 mW/cm² for 200 hours and decrease in conversion efficiency was not observed.

### (Example 2)

The photoelectric conversion device according to Example 2 of the present invention is different from Example 1 only in that the thickness of the intervening layer 321 is increased to 5 nm.

Output characteristics of the photoelectric conversion device obtained in Example 2 were measured by radiating light of AM 1. 5 at normal temperature with a light amount of 100 mN/cm², Voc was 0.548 V, Jsc was 25.2 mA/cm², F.F. was 0.720, and Eff. was 9.9%. These characteristics in Example 2 are also summarized in Table 1.

In Example 2 compared with Example 1 and Comparative Example 1, even though the thickness of the intervening layer 321 is increased from 2 nm to 5 nm, it is found that the same improved photoelectric conversion characteristics as the case of Examples 1 are obtained as compare with Comparative Example 1.

### (Example 3)

The photoelectric conversion device according to Example 3 of the present invention is different from Example 1 only in that the i-type crystalline silicon carbide (µc-SiC) layer having a thickness of 2 nm is deposited by replacing carbon dioxide gas with methane in forming the intervening layer 321.

Output characteristics of the photoelectric conversion device obtained in Example 3 were measured by radiating light of AM 1.5 at normal temperature with an intensity of 100 mM/cm², Voc was 0.539 V, Jsc was 25.0 mA/cm², F.F. was 0.718, and Eff. was 9.7%. These characteristics in Example 3 are also summarized in Table 1.

In Example 3 compared with Example 1 and Comparative Example 1, even though the material for the intervening layer 321 is modified from i-type µc-SiO to i-type µc-SiC, it is found that approximately the same improved photoelectric conversion characteristics as in Example 1 are obtained as compared with Comparative Example 1.

### (Comparative Example 2)

The photoelectric conversion device in Comparative Example 2 is different from Example 1 only in that the intervening layer 321 is deposited as the substantially i-type amorphous silicon (a-Si) thin film having a thickness of 2.7 nm by approximately the same method as the case of Patent Document 1.

Output characteristics of the photoelectric conversion device obtained in Comparative Example 2 were measured by radiating light of AM 1.5 at normal temperature with an intensity of 100 mW/cm². Voc was 0.529 V, Jsc was 24.7 mA/cm², F.F. was 0.721, and Eff. was 9.4%. These characteristics in Comparative Example 2 are also summarized in Table 1.

As can be seen from Table 1, in Comparative Example 2 as compared with Example 1, the values of Voc and Jsc were deteriorated to consequently impair Eff. The reason therefor is conceived to be that the i-type a-Si intervening layer causes limits in the role of improving characteristics of the crystalline silicon photoelectric conversion layer 322 deposited thereon in the case where the transparent electrode 2 has a haze ratio of 25% which is more than 20%.

### (Comparative Example 3)

The photoelectric conversion device in Comparative Example 3 is different from Example 3 only in that the intervening layer 321 is deposited as the p-type µc-SiC layer having a thickness of 3 nm by approximately the same method as Example 2 described in Patent Document 2.

In the photoelectric conversion device obtained in Comparative Example 3, when output characteristics were measured by radiating light of AM 1.5 at normal temperature with an intensity of 100 mW/cm², Voc was 0.519 V, Jsc was 24. 5 mA/cm², F.F. was 0.715, and Eff. was 9.1%. These characteristics in Comparative Example 3 are also shown together in Table 1.

As can be seen from Table 1, in Comparative Example 3 as compared with Example 3, the values of Voc and Jsc were deteriorated to consequently deteriorate Eff. The reason therefor is assumed to be that absorption loss of incident light is caused in the p-type µc-SiC layer inserted as the intervening layer 321.

### (Summary of comparison between Examples and Comparative Examples)

As can be seen from the results summarized in Table 1, any of Examples 1 to 3 allows the thin-film photoelectric conversion device with better conversion efficiency than Comparative Examples 1 to 3. In other words, any of Examples improves the values of Voc and Jsc more than any of Comparative Examples to consequently improve conversion efficiency Eff. The reason therefor is assumed to be that the presence of the i-type crystalline silicon-based intervening layer 321 allows the barrier effect of restraining p-type impurities from diffusing from the p-type layer 31 into the i-type crystalline photoelectric conversion layer 322, and the effect of preventing hydrogen atoms in the plasma in depositing the crystalline photoelectric conversion layer 322 from adversely affecting the p-type layer 31. It is assumed that the i-type crystalline silicon-based intervening layer 321 may favorably cover the p/i layer interface reflecting the surface shape of the transparent electrode 2, even in the case of using the transparent electrode 2 having as high a haze ratio as 25% such as Examples, which means large surface irregularity. Thus, it is assumed that the nucleus generation in the i-type crystalline photoelectric conversion layer 322 formed subsequently on the intervening layer is controlled by the i-type crystalline silicon-based intervening layer 321, the growth initial film quality of the p/i layer interface on the i-type crystalline photoelectric conversion layer 322 side is made into high quality, and carrier recombination due to defect in the film is inhibited, so that conversion efficiency is improved. In addition thereto, it is conceived that since the i-type crystalline silicon-based intervening layer 321 is a crystalline and i-type layer, light absorption by the intervening layer is so small that generated current in the i-type crystalline photoelectric conversion layer is not decreased even though located on the light incidence side of the i-type crystalline photoelectric conversion layer 322, whereby Jsc is improved.

Examples with specific characteristic numerical values were not shown; however, it is confirmed that the same effect is obtained even though a crystalline silicon nitride layer is applied to the intervening layer 321. It is confirmed that the effects of Examples 1 to 3 are not lost also in a tandem type photoelectric conversion device, in which the crystalline photoelectric conversion unit of Examples 1 to 3 and the amorphous silicon photoelectric conversion unit are stacked

### INDUSTRIAL APPLICABILITY

As described above, according to the present invention, the utilization of the i-type crystalline silicon-based intervening layer allows the crystalline silicon-based thin-film photoelectric conversion layer to be of higher quality and the characteristics of a semiconductor junction to be improved, so that a silicon-based thin-film photoelectric conversion device with conversion efficiency improved may be provided at low cost by a plasma enhanced CVD method.

## Claims

1. A silicon-based thin-film photoelectric conversion device comprising a crystalline photoelectric conversion unit including a one-conductivity-type semiconductor layer, a crystalline silicon-based photoelectric conversion layer, and a reverse-conductivity-type semiconductor layer, laminated sequentially;
and further comprising a substantially i-type crystalline silicon-based intervening layer between the one-conductivity-type semiconductor layer and the photoelectric conversion layer, wherein the substantially i-type crystalline silicon-based intervening layer is made of a material different from the photoelectric conversion layer; and wherein
the photoelectric conversion layer contacts directly with the intervening layer.

2. The silicon-based thin-film photoelectric conversion device according to claim 1, further comprising a transparent electrode having surface irregularities on a light incidence side of the crystalline photoelectric conversion unit; wherein
a haze ratio of the transparent electrode is 20 to 40%.

3. The silicon-based thin-film photoelectric conversion device according to claim 1 or 2, wherein a thickness of the intervening layer is within a range of 0.1 to 10 nm.

4. The silicon-based thin-film photoelectric conversion device according to any one of claims 1 to 3, wherein the intervening layer contains crystalline silicon oxide.

5. The silicon-based thin-film photoelectric conversion device according to any one of claims 1 to 3, wherein the intervening layer contains at least one of crystalline silicon carbide and crystalline silicon nitride.

6. The silicon-based thin-film photoelectric conversion device according to any one of claims 1 to 5, further comprising an amorphous photoelectric conversion unit including a one-conductivity-type semiconductor layer, an amorphous silicon-based photoelectric conversion layer, and a reverse-conductivity-type semiconductor layer stacked sequentially on a light incidence side of the crystalline photoelectric conversion unit.
